# EUROPEAN PATENT SPECIFICATION

(11) **EP 2 693 449 B1**
(45) Date of publication and mention of the grant of the patent: **15.11.2017**
(21) Application number: 12305942.0
(22) Date of filing: 31.07.2012
(51) Int. Cl.: H01B 12/06, H01L 39/16, H01B 5/00

(54) **Electric conductor element**
Elektrisches Leiterelement
Élément conducteur électrique

(43) Date of publication of application: 05.02.2014
(73) Proprietor: Nexans, 92400 Courbevoie (FR)
(72) Inventor: Ehrenberg, Jürgen, 50354 Huerth (DE); Schramm, Judith, 52499 Baesweiler (DE); Hobl, Achim, 51503 Rösrath (DE)
(74) Representative: Feray, Valérie

(56) References cited:
- EP-A1- 2 117 056
- WO-A1-97/29491
- WO-A1-2008/009537
- GB-A- 1 278 219
- US-A- 2 351 927

## Description

The present invention relates to electric conductors in general and the installation thereof in electric devices.

Electric conductors may be electrically normally conducting conductors as well as conductors made of superconducting material, in particular high temperature superconducting (HTS) material (superconductors and HTS conductors, respectively).

Electric conductors of both types are widely used in the production of electric devices, such as cables for electric transmission, induction windings etc.

An interesting application field of superconductors, in particular HTS conductors, are fault current limiters and HTS-based cables due to the unique property of HTS materials to have zero resistance when cooled down below their critical temperature and to become resistive in case of excess current, that is in fault event, for example short circuit.

However, in operation of all those electric conductors cooling mechanisms must be provided for dissipating heat generated by the conductors, for example due to AC losses or eddy current. In case of superconductors thermal insulation and cooling system for cooling down the superconductor to its critical temperature and maintaining it at this temperature are essential.
In addition, in a fault current limiter in fault event within a very short time period of only some milliseconds a high amount of heat and energy is generated which must be immediately led away to cool the superconductor back to operating conditions.

These requirements pose some difficulties in the installation of electrical conductors in such electrical devices.

For electric insulation it is known to provide a sheet or layer of electrically insulating material between two adjacent electrical conductors or to clad an electrical conductor with an electrically insulating material.

In US 3,595,982 a superconducting alternating current cable is disclosed with coaxially arranged tubular superconducting conductors, said superconducting conductors comprising a ceramic tube and a layer of superconducting material. The annular gap between two coaxially arranged superconducting conductors is filled with cooling medium for cooling and insulation. Since such gaseous or liquid cooling medium cannot maintain the conductors separate, spacers of solid insulating material are provided. The spacers are plastic fibers which are wound helically along the longitudinal extension of the inner tubular conductor. It is stated, that, due to the helical shape the spacer can be compressed to such an extent during installation of the outside conductor, that it does not become loose following the cooling process and does not experience any mechanical extension which occurs between materials having dissimilar coefficients of expansion.

Another type of spacer is disclosed in US 3,619,474 which is also directed to a superconducting cable. In this coaxial design the superconducting conductors are housed within a central tubular member with two further tubular members being disposed concentrically to provide an inner and outer annular gap. Within the central tubular member and the outer annular gap cooling medium of different types is present with the cooling medium within the central tubular member having a lower temperature than that in the outer gap. The inner annular gap is evacuated and a spacer is provided therein having only a small contact area with the surrounding intermediate tubular member for minimizing heat loss. The spacer is a ribbon carrying on one side small geometrical bodies with round, cylindrical or rectangular shape with the ribbon being wound helically onto the inner tubular member with the geometric bodies oriented outwardly. Due to their shape the contact area of the geometrical bodies with the intermediate tubular member is only small for reducing heat transfer.

US-Patent 2,351,927 discloses a spacer means for a coaxial cable with inner and outer conductor which simultaneously serves as insulation means wherein the spacer means is applied onto the inner conductor.
The spacer means is formed by at least two strips having a plurality of openings arranged along the centerline of each strip, wherein each strip is corrugated to a zig-zag-shape. The two strips are threaded onto the inner conductor in an interlaced manner and are twisted by 90° relative to each other to form a continuous helical line along the conductor.

WO 2008/009537 A1 relates to a flat bifilar coil wherein the bifilar coil is formed from a holding element which holds the superconductor band and simultaneously serves as insulating and spacing means. The holding element is composed of flat band and a corrugated band fixed onto one face of the flat band and extending in parallel thereto. Due to the corrugation the corrugated band has regions close to the flat band and regions away from the flat band. In the regions away from the flat band recessions are provided in parallel to the longitudinal direction of the holding element, wherein the superconductor band is accommodated into these recessions. In the wound state the superconductor band is held by the recessions and the flat band serves to insulate adjacent windings.

WO 02/093589 A1 discloses an electric cable for high voltage application incorporating an electric conductor wherein the electric cable is used in the production of an induction winding to be used in electric devices for high voltage applications, for example in rotating machines such as motors and generators. The electric cable is composed of an electric conductor surrounded by an insulation system comprising a semiconducting layer and compressed gas that provides electric insulation and facilitates cooling of said electric conductor, wherein this assembly is located at the center of an enclosure. Spacers are provided for supporting the electric cable substantially at the center of the enclosure. Said spacers are manufactured either together with the enclosure or together with the electric cable. The spacers extend radially between the outer surface of the electric cable and the inner wall of the enclosure such as annular discs running around the cable leaving channels for facilitate flow of cooling medium. According to another embodiment the spacer is a helix running along the gap between cable and enclosure. It is stated that said spacers serve to withstand vibration generated by currents having certain frequency and changes in dimension due to thermal expansion.

WO 2011/159176 A1 relates to a Roebel cable with HTS conductors, wherein at least some of the HTS conductors are separated by a spacer for reducing AC transport losses. The spacers are sheets provided between individual HTS conductors. The sheets may be planar or profiled, e.g. corrugated, ripped etc., for facilitating access of cooling medium.

EP 2 117 056 A1 relates to HTS conductors to be used in a fault current limiter wherein the HTS conductors are provided with metallic means for efficiently dissipating thermal and electrical energy generated in fault event when the superconductor quenches, i.e. becomes resistive.

The superconductor is a coated conductor, also referred to second generation superconductor, which are typically of long length and are composed of a substrate onto which is applied a multilayer architecture with a HTS layer and one or more buffer layers there between.

According to one embodiment the superconductor assemblies are arranged into a stack with adjacent superconductor assemblies being spaced apart by spacers made of electric insulating material and being a plate or layer. The spacers can be provided with grooves, openings etc. for allowing direct contact of the superconductor with the cooling medium.

In fault current limiters using coated conductors a long length of coated conductor must be accommodated, preferably, in a space-saving manner, to keep the size of the device as small as possible. To this it is known to coil the coated conductor tapes to a spiral and the needed number of spirals are mounted within the fault current limiter.
For electric insulation the coated conductor tapes are fixed, for example, by gluing, onto a tape made of insulating material and are covered with a second tape of insulating material. The whole structure is then coiled to the spiral. However, exact positioning and fixation of the coated conductor onto the insulating tape is cumbersome. Further, detachment and, in the consequence, displacement of the coated conductor tape is likely to occur, for example, due to tension forces generated during cooling as a result of differing thermal expansion of the materials used.

For allowing sufficient access of cooling medium spacers must be provided between the two insulating tapes enclosing the coated conductor. This increases the number of components to be assembled and the process steps for mounting the coated conductor.

As is clear from the above the main function of the known spacers is to spatially separate adjacent components and thermally and/or electrically isolate them from each other. In some cases the spacers serves to compensate dimensional change due to temperature changes during operation.

There is a demand for a means which is suited to hold an electrical conductor securely in place within an electrical device and fix it, and which can be easily handled. According to a further aspect the means shall allow space-saving installation for keeping the overall dimension of the device as small as possible.

According to the present invention an electric conductor element is provided composed of at least one electric conductor and a carrier member made of electrically insulating material, wherein the carrier member comprises at least one row of openings with consecutive openings are separated from one another by a pre-determined distance, and wherein the electric conductor is threaded through a row of openings.

The arrangement of the present invention allows easy installation of the electric conductor within an electric device with the electric conductor being not only securely held in place by the openings but also fixed and protected from shifting due to mechanical and/or electrical forces generated during operation.

The present invention is likewise suitable for normally conducting conductors as well as for superconductors including high temperature superconductors.

The electric conductor can have any suitable cross-sectional shape, such as rectangular, round, oval, etc.
The electric conductor may be a tape with two plane faces or a round wire. The carrier member, primarily, stabilizes the electric conductor and holds it securely in place.

The carrier member can have a dimension corresponding to the dimension of the electric conductor. Typically, the carrier member has a wider width than the electric conductor so that the side strips of the carrier member extend beyond the longitudinal edges of the electrical conductor.

The carrier member has a plurality of openings which are arranged in a linear row with adjacent openings being spaced from one another by a pre-determined distance. The openings can be holes or slits. They can be cuts provided alternately along the opposite longitudinal edges of the carrier member with overlapping section formed by the end sections of the cuts for holding the electrical conductor.

The pre-determined distance between adjacent openings can be freely chosen but should be such to allow stable and strong holding of the conductor.
The number of openings depends on the length of the electric conductor and can be selected according to need.

The openings have a shape and dimension corresponding to the cross sectional shape and dimension of the electric conductor. For facilitating threading through of the electrical conductor the size of the openings is typically a little bit greater than the size of the electrical conductor but should be sufficiently small to hold the electrical conductor safe and to avoid shifting within the openings.
In case of cuts the end sections forming the overlapping section can be widened.

Typically the carrier member is a tape with planar main faces.
One or both of the main faces can be provided with a relief, such as ribs and/or may be perforated for improved contact with the cooling medium.

The carrier member is made from an electrically insulating material and is preferably flexible for facilitating mounting within an electric device.

Examples for suitable materials are synthetic materials such as polyimide (PI), e.g. those one sold under the trade name "Kapton" of Dupont Company, other plastic materials such as polyvinylchloride (PVC), polyethylene (PE), polyamide (PA), polyurethane (PUR), glass fiber reinforced plastic (GRP), flexible ceramic compound material, e.g. those one sold under the trade name "ccflex" of Marburg Company, polypropylene laminated paper (PPLP), Kraft-paper etc.

The thickness of the carrier member may be selected depending on the nature of the electric conductor and specific application.
For example, the tolerable bending radius of the electric conductor should be considered for avoiding damage of the electric conductor since with increasing thickness of the carrier member the bending radius is increased when threading the electric conductor through the openings.

Spacers can be provided onto one or both of the protruding side strips of the carrier member at least on one of the faces of the carrier member.

According to a further embodiment the carrier member can be pushed together to form a corrugation such as a wave or zig-zag shape. In this embodiment the carrier member simultaneously serves as spacer and entry of cooling medium is facilitated.

The corrugation may extend over the whole longitudinal extension of the electric conductor or can be formed in sections with sections without corrugation and sections with corrugation.

The length of the carrier member can be selected according to need.
For example in case of corrugation the carrier member may be longer than the electric conductor.

According to a further embodiment as the HTS conductor a "second generation" or 2G HTS conductor, also referred to coated conductor, is used, which is produced as a HTS thin film on a tape shaped substrate coated with one or more oxide films as buffer layers. The buffer layers serve to compensate for the various different properties of the materials used. According to need further layers may be applied onto the HTS layer, for example a copper layer to protect the HTS layer from thermal-electrical instability. The HTS thin film can be composed of Re-Ba-Cu-O and preferably of YBCO-123.

The HTS conductor can be a PIT conductor using BSCCO-2223 or BSCCO-2212 manufactured by a powder-in-tube (PIT) process involving drawing, rolling and thermal treatment processes wherein the superconducting material is sheathed within silver or silver alloy.

In the practice of the invention any known electrically normally conducting conductor can be used such as those based on metals, e.g. copper etc., conducting carbon and carbon compounds, e.g. graphite, semiconducting materials etc.

The present invention is further illustrated with reference to the accompanying figures showing preferred embodiments of the electric conductor element of the present invention:
It is shown in
   - **figure 1**: a schematic drawing of a preferred embodiment of the present invention;
   - **figure 2**: a top view of the embodiment of figure 1;
   - **figure 3**: a further preferred embodiment of the present invention;
   - **figure 4**: a modification of the electric conductor element of the present invention using the embodiment of figure 1 as an example; and
   - **figure 5**: further modification of the electric conductor element of the present invention using the embodiment of figure 1 as an example.

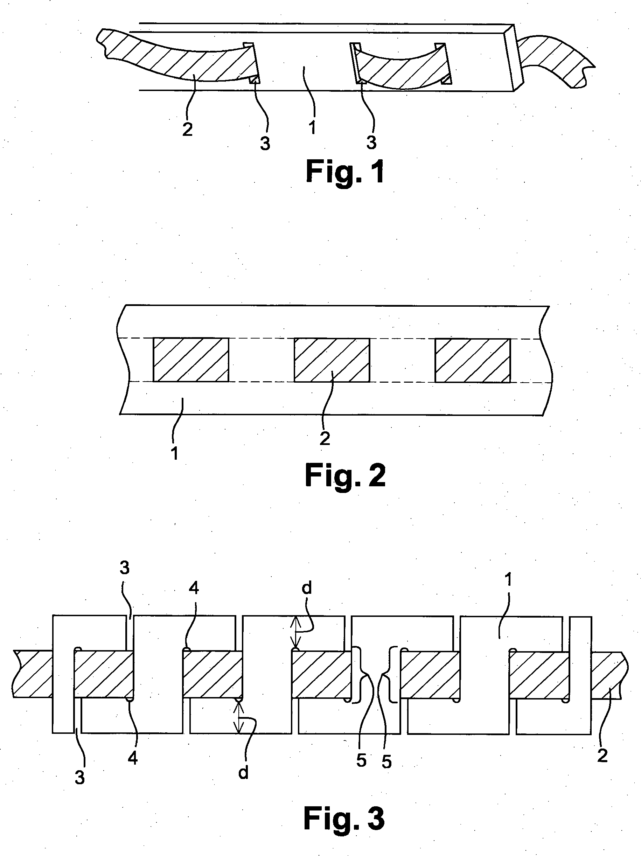

Shown in **figure 1** is an electric conductor element of the present invention with a carrier member 1 and an electric conductor tape 2 which is threaded through openings 3 provided in the carrier member 1.
The openings 3 are arranged in a row along the longitudinal extension of the carrier member.

The electric conductor tape 2 runs alternately on the upper and lower faces of the carrier member 1 and is positioned in the middle of the carrier member 1. By threading through the openings 3 the electric conductor is protected from shifting and securely held in its position in the middle of carrier member 1.
Such a design is advantageous in that no further fixation is necessary, such as for example gluing or soldering etc.

In the embodiment of figure 1 the carrier member 1 is wider than the electric conductor 2 with side strips protruding on the left and right side of the electric conductor 2. This embodiment is advantageous in that the carrier member 1 electrically isolates the electric conductor 2 against adjacent electric conductors.

In figure 1, the openings 3 are slits which are spaced in equal distance. However, depending on the shape of the electric conductor the shape of the openings 3 can vary. For example the openings 3 can be essentially round in case of an electric conductor of round cross section. Further, also the distance between adjacent openings 3 can vary. The distances can be equal or can be different.
For example, there can be groups of openings 3 with equal distances wherein the groups are spaced from each other by a different distance or the distance between adjacent openings 3 in a row can alternately vary.

There may be two or more, preferably parallel, rows of openings 3 provided in the carrier member 1.

The openings 3 can be produced with well established technical procedures such as cutting, e.g. with steel blades, water jet, laser beam, stamping or chemical etching processes.

A top view on the electric conductor of figure 1 is shown in **figure 2** with the dashed lines indicating those parts of the electric conductor 2 running on the lower face of the carrier member 1.

In the embodiment of **figure 3** the openings 3 are formed by cuts which are provided alternately in the opposite longitudinal edges of the carrier member 1. Adjacent opposite cuts are spaced from each other by a pre-determined distance. The cuts on each side of the carrier member 1 extend until an end point 4 towards the opposite longitudinal edge of the carrier member 1 with the end points 4 being spaced from the respective opposite longitudinal edge at a distance d. Distance d of cuts starting from the same side of the carrier member 1 are essentially equal in length. Distance d of cuts starting from different sides of the carrier member 1 may be equal or may be different in length.

Preferably, the cuts are in parallel to each other and are essentially rectangular with respect to the longitudinal edge from which they start.

As shown in **figure 3****,** the end sections of cuts starting from opposite longitudinal edges overlap and form an overlapping section 5 for receiving and holding the electrical conductor 2.

Preferably the overlapping section 5 is located along the centerline of the carrier member 1.

The dimensions of the overlapping section 5 depends on the dimensions of the electrical conductor 2 and is select sufficient to hold the electrical conductor securely in place. The portion of the cuts extending between starting point and overlapping section may be narrower than the width of the cuts in the overlapping section 5 for improved holding of the electrical conductor, that is the end portions of the cuts for receiving and holding the electrical conductor 2 may be wider than the remaining cut portion.

By the cuts threading of the electrical conductor 2 is facilitated but nevertheless the electrical conductor is held securely in place due to the alternating arrangement of the cuts.
The cuts results in an meander like shape of the carrier member.

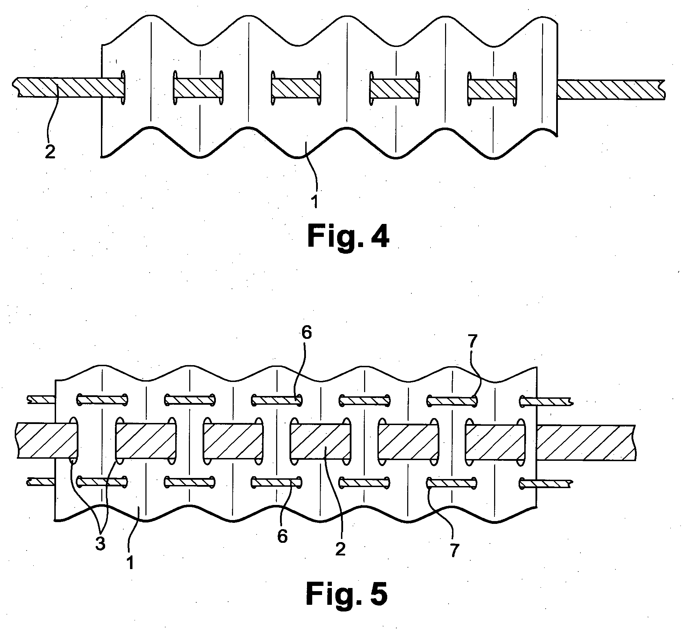

A preferred embodiment of the electric conductor element of the present invention is shown in figure 4. In this embodiment the carrier member 1 is pushed together to form a wave structure. Such a wave structure or corrugation is advantageous in that the carrier member 1 can function as a spacer and, simultaneously, access of cooling medium as facilitated. Depending on the extent of corrugation the depths of the waves can be adjusted.

In the modification shown in **figure 5** a plurality of further openings 7 is provided within the carrier member 1 along the longitudinal edges of the electric conductor 2. Preferably the opening 7 are arranged in parallel rows within the carrier member 1 along the longitudinal edges of electric conductor 2. Typically the openings 7 are smaller than the openings 3 for receiving the electric conductor 2. A cord 7 is threaded through said parallel rows of further opening 7. The cord 6 typically projects above the electrical conductor 2 and serve as sparer.

The cord 6 can be made of any electrically insulating material such as referred to above with respect to the carrier member 1. For example, the cord 6 can be made from plastic fibers or GRP.

The electric conductor element of the present invention is particularly suitable for mounting a coated conductor as the electrical conductor 2 within a fault current limiter. To this a row of openings 3 is produced in a tape like carrier member 1 wherein the row is positioned preferably in the middle of the carrier member. Then, a coated conductor tape is threaded through the openings 3. Due to the openings the coated conductor is securely held in place and fixed without further steps such as gluing etc.. The coated conductor is protected against detachment and/or displacement even in case of dimensional changes due to temperature changes such as on cooling down to operational temperature.
Then, the electric conductor element with carrier member 1 and threaded through coated conductor is coiled to a spiral which can be mounted within a fault current limiter.

Preferably, the carrier member 1 is corrugated prior to coiling the coated conductor. The coated conductor is positioned along the centre line of the carrier member 1 and is smaller than the carrier member 1 so that edge stripes of the carrier member 1 protrude beyond the longitudinal edges of the coated conductor. By these protruding edge stripes the coated conductor is electrically isolated towards adjacent coated conductors or other electric conductor elements according to the present invention.

According to need one or both faces of the electric conductor element with coated conductors can be covered with a tape made of electrically insulating material for electric insulation.
As the electrically insulating material a material can be used as mentioned above with respect to the carrier member. Preferably, the electrical insulating material is the same as that of the carrier member.

It is also possible to have two or more electric conductors onto one carrier member.

By the carrier member the electric conductor, e.g. coated conductor, is stabilized and held in position even if subjected to great mechanical and electrical forces as maybe generated during operation of a fault current limiter.

### List of reference numerals

- 1: carrier member
- 2: electric conductor
- 3: openings
- 4: end point of cut
- 5: overlapping section
- 6: cord
- 7: further openings

## Claims

1. Electric conductor element comprising a carrier member (1), an electric conductor (2), and a row of openings (3) provided in the carrier member (1) for threading through the electric conductor (2),
**characterized in**
**that** at least one row of openings (3) is provided in the carrier member (1), wherein consecutive openings (3) are separated from one another by a predetermined distance, and
wherein the electric conductor is threaded through one row of openings (3).

2. Electric conductor element according to claim 1
comprising two or more electric conductors (2) each threaded through a row of openings (3) onto the carrier member (1).

3. Electric conductor element according to claim 1 or 2,
**wherein** the openings (3) are selected from holes, slits and cuts.

4. Electric conductor element according to claim 3,
**wherein** the openings (3) are formed by plurality of cuts which are provided alternately along the opposite longitudinal edges of the carrier member (1) and extending across the carrier member (1) until an end point (4) which is spaced from the respective opposite longitudinal edge at a distance d,
**wherein** the end sections of the cuts form an overlapping section (5) for receiving and holding the electric conductor (2).

5. Electric conductor element according to any of the preceding claims,
**wherein** the carrier member (1) is wider than the electric conductor (2) with side strips protruding beyond the longitudinal edges of the electric conductor (2).

6. Electric conductor element according to any of the preceding claims,
**wherein** the carrier member (1) is pushed together to form a corrugation.

7. Electric conductor element according to any of the preceding claims,
**wherein** the electric conductor (2) is selected from an electric normally conducting conductor and a superconducting conductor.

8. Electric conductor element according to claim 7,
**wherein** the electric conductor (2) is a high temperature superconducting conductor.

9. Electric conductor element according to any of the preceding claims,
**wherein** the electric conductor is selected from a coated conductor and a PIT superconductor.

10. Electric conductor element according to any of the preceding claims,
**wherein** the carrier member (1) is made from a plastic material and
**wherein** the electric conductor (2) is a coated conductor of high temperature superconducting material.

11. Electric conductor element according to any of the preceding claims,
wherein spacers are provided onto at least one of the side strips of the carrier member (1) produding beyond the longitudinal edges of the electric conductor (2).

12. Use of an electric conductor element according to an any of the preceding claims in a fault current limiter,
**wherein** the electric conductor (2) is a high temperature superconducting conductor.

## Patentansprüche

1. Elektrisches Leiterelement, umfassend ein Trägerelement (1), einen elektrischen Leiter (2) und eine Reihe von Öffnungen (3), die im Trägerelement (1) zum Durchfädeln des elektrischen Leiters (2) vorgesehen sind,
**dadurch gekennzeichnet, dass**
mindestens eine Reihe von Öffnungen (3) im Trägerelement (1) vorgesehen ist, wobei aufeinander folgende Öffnungen (3) um einen vorbestimmten Abstand voneinander getrennt sind, und
wobei der elektrische Leiter durch eine Reihe von Öffnungen (3) durchgefädelt ist.

2. Elektrisches Leiterelement nach Anspruch 1,
umfassend zwei oder mehr elektrische Leiter (2), die jeweils durch eine Reihe von Öffnungen (3) auf dem Trägerelement (1) durchgefädelt sind.

3. Elektrisches Leiterelement nach Anspruch 1 oder 2,
wobei die Öffnungen (3) aus Löchern, Schlitzen und Ausschnitten ausgewählt sind.

4. Elektrisches Leiterelement nach Anspruch 3,
wobei die Öffnungen (3) durch eine Mehrzahl von Ausschnitten ausgebildet sind, die entlang der gegenüberliegenden Längskanten des Trägerelements (1) abwechselnd vorgesehen sind und sich über das Trägerelement (1) bis zu einem Endpunkt (4) erstrecken, der von der jeweiligen gegenüberliegende Längskante in einem Abstand d beabstandet ist, wobei die Endabschnitte der Ausschnitte einen Überlappungsabschnitt (5) zum Aufnehmen und Halten des elektrischen Leiters (2) bilden.

5. Elektrisches Leiterelement nach einem der vorhergehenden Ansprüche,
wobei das Trägerelement (1) breiter als der elektrische Leiter (2) ist, wobei Seitenstreifen über die Längskanten des elektrischen Leiters (2) hinaus vorstehen.

6. Elektrisches Leiterelement nach einem der vorhergehenden Ansprüche,
wobei das Trägerelement (1) zusammengedrückt ist, um eine Welligkeit zu bilden.

7. Elektrisches Leiterelement nach einem der vorhergehenden Ansprüche,
wobei der elektrische Leiter (2) aus einem normal leitenden elektrischen Leiter und einem supraleitendem Leiter ausgewählt ist.

8. Elektrisches Leiterelement nach Anspruch 7,
wobei der elektrische Leiter (2) ein supraleitender Hochtemperaturleiter ist.

9. Elektrisches Leiterelement nach einem der vorhergehenden Ansprüche,
wobei der elektrische Leiter aus einem beschichteten Leiter und einem PIT-Supraleiter ausgewählt ist.

10. Elektrisches Leiterelement nach einem der vorhergehenden Ansprüche,
wobei das Trägerelement (1) aus einem Kunststoffmaterial hergestellt ist, und wobei der elektrische Leiter (2) ein beschichteter Leiter aus supraleitendem Hochtemperaturmaterial ist.

11. Elektrisches Leiterelement nach einem der vorhergehenden Ansprüche,
wobei Abstandshalter auf mindestens einem der Seitenstreifen des Trägerelements (1) vorgesehen sind, die über die Längskanten des elektrischen Leiters (2) hinaus vorstehen.

12. Verwendung eines elektrischen Leiterelements nach einem der vorhergehenden Ansprüche in einem Kurzschlussstrombegrenzer,
wobei der elektrische Leiter (2) ein supraleitender Hochtemperaturleiter ist.

## Revendications

1. Élément conducteur électrique comprenant un élément de support (1), un conducteur électrique (2), et une rangée d'ouvertures (3) prévue dans l'élément de support (1) pour l'enfilage dans le conducteur électrique (2),
**caractérisé en ce que**
la au moins une rangée d'ouvertures (3) est prévue dans l'élément de support (1), les ouvertures consécutives (3) étant séparées les unes des autres par une distance prédéterminée, et
dans lequel le conducteur électrique est enfilé dans une rangée d'ouvertures (3).

2. Élément conducteur électrique selon la revendication 1, comprenant deux conducteurs électriques (2) ou plus chacun enfilés dans une rangée d'ouvertures (3) sur l'élément de support (1).

3. Élément conducteur électrique selon la revendication 1 ou 2,
dans lequel les ouvertures (3) sont choisies parmi des orifices, des fentes et des découpes.

4. Élément conducteur électrique selon la revendication 3,
dans lequel les ouvertures (3) sont formées par une pluralité de découpes qui sont prévues de manière alternée le long des bords longitudinaux opposés de l'élément de support (1) et qui s'étendent au sein de l'élément de support (1) jusqu'à un point final (4) qui est espacé des bords longitudinaux opposés respectifs à une distance d,
dans lequel les sections d'extrémité des découpes forment une section de chevauchement (5) destinée à recevoir et à maintenir le conducteur électrique (2).

5. Élément conducteur électrique selon l'une quelconque des revendications précédentes,
dans lequel l'élément de support (1) est plus large que le conducteur électrique (2) avec des bandes latérales qui sortent au-delà des bords longitudinaux du conducteur électrique (2).

6. Élément conducteur électrique selon l'une quelconque des revendications précédentes,
dans lequel l'élément de support (1) est poussé afin de former une ondulation.

7. Élément conducteur électrique selon l'une quelconque des revendications précédentes,
dans lequel le conducteur électrique (2) est choisi parmi un conducteur électrique normalement conducteur et un conducteur supraconducteur.

8. Élément conducteur électrique selon la revendication 7,
dans lequel le conducteur électrique (2) est un conducteur supraconducteur à haute température.

9. Élément conducteur électrique selon l'une quelconque des revendications précédentes,
dans lequel le conducteur électrique est choisi parmi un conducteur enduit et un supraconducteur PIT.

10. Élément conducteur électrique selon l'une quelconque des revendications précédentes,
dans lequel l'élément de support (1) est composé d'un matériau plastique, et
dans lequel le conducteur électrique (2) est un conducteur enduit en matériau supraconducteur à haute température.

11. Élément conducteur électrique selon l'une quelconque des revendications précédentes,
dans lequel des entretoises sont prévues sur au moins l'une des bandes latérales de l'élément de support (1) qui sortent au-delà des bords longitudinaux du conducteur électrique (2).

12. Utilisation d'un élément conducteur électrique selon l'une quelconque des revendications précédentes dans un limiteur de courant de défaut,
dans lequel le conducteur électrique (2) est un conducteur supraconducteur à haute température.
